# EUROPEAN PATENT SPECIFICATION

(11) **EP 2 725 569 B1**
(45) Date of publication and mention of the grant of the patent: **30.03.2016**
(21) Application number: 12802109.4
(22) Date of filing: 22.06.2012
(51) Int. Cl.: G09F 9/00, B60R 11/02, H04N 5/64

(54) **DISPLAY HOLDING MECHANISM AND OPENABLE DISPLAY APPARATUS**
ANZEIGEHALTEMECHANISMUS UND ANZEIGEVORRICHTUNG ZUM ÖFFNEN UND SCHLIESSEN
MÉCANISME DE RETENUE D'AFFICHAGE ET DISPOSITIF D'AFFICHAGE DE TYPE À OUVERTURE ET À FERMETURE

(30) Priority: 23.06.2011 JP 2011139544
(43) Date of publication of application: 30.04.2014
(73) Proprietor: Panasonic Intellectual Property Management Co., Ltd., Osaka 540-6207 (JP)
(72) Inventor: AOKI, Masayoshi, Osaka 540-6207 (JP)
(74) Representative: Grünecker Patent- und Rechtsanwälte PartG mbB
(86) International application number: PCT/JP2012/004043
(87) International publication number: WO 2012/176462

(56) References cited:
- WO-A1-2007/000857
- WO-A1-2010/001511
- WO-A1-2011/016093
- JP-A- 2 174 475
- JP-A- 4 005 142
- JP-A- 2004 214 791
- JP-A- 2007 125 961
- JP-A- 2007 131 037
- JP-A- 2009 166 582
- JP-A- 2011 031 798
- US-A1- 2008 256 748

## Description

### [Technical Field]

The present invention relates to a display holding mechanism for holding a pivotable display, and an openable display apparatus including the display holding mechanism.

### [Background Art]

In recent years, minivans and full-size cars include a display apparatus for a rear sheet. The display apparatus for a rear sheet is secured to, for example, an inside of a ceiling of a vehicle so that a display is pivotable. When the apparatus is not used, the display is stored in a storage position in a casing so as not to block a front view, while when the apparatus is used, the display is pivoted to a use position and protrudes downward.

Such a display apparatus includes a locking mechanism for locking the display in the storage position so that the stored display is not pivoted toward the use position. For example, in Patent Literature 1, when a display reaches a storage position, a locking cam having a locking pawl is pivoted so as to fit into a notch formed in the display to lock the display in the storage position.

A display locking mechanism described in Patent Literature 2 includes a braking member that fastens a rotating shaft of a display from outside to brake the display in a use position with a frictional force against the rotating shaft. This prevents a rattle of the display in the use position due to backlash of gears that constitute a gear mechanism for pivoting the display.

Patent Literature 3 discloses a display holding mechanism according to the preamble of claim 1.

### [Citation List]

### [Patent Literature]

[Patent Literature 1] Japanese Patent Laid-Open No. 2007-153303
[Patent Literature 2] Japanese Patent Laid-Open No. 2007-171922
[Patent Literature 3] US 2008/256748 A1

### [Summary of Invention]

### [Technical Problem]

The display locking mechanism described in Patent Literature 2 is configured to brake the display in both the use position and the storage position, but when vibration or the like of a vehicle makes a strong impact on the display, the display may be pivoted from the storage position to the use position. In particular, once the display is pivoted in the case where the display apparatus is not powered on (the case where power is not supplied to a motor of the display locking mechanism), the display is not returned to the storage position unless the display apparatus is again powered on, which is inconvenient.

Thus, the locking mechanism described in Patent Literature 1 is preferably combined with the display locking mechanism described in Patent Literature 2 to reliably lock the display in the storage position and prevent a rattle of the display in the use position. However, in this case, a locking motor for locking the display in the storage position, and a braking motor for braking the display in the use position are separately required, which presents a problem in terms of a reduction in size and cost of the apparatus.

The present invention is achieved under the above described background. The present invention has an object to provide a display holding mechanism that can reliably hold a display in a use position and a storage position with a simple configuration.

### [Solution to Problem]

An aspect of the present invention provides a display holding mechanism including: a display locking portion that locks a display in a storage position; a display braking portion that brakes the display in a use position; and a switching member that selectively engages the display locking portion and the display braking portion, wherein the switching member engages the display locking portion in a first position to lock the display in the storage position, and engages the display braking portion in a second position to brake the display in the use position.

As described below, the present invention includes other aspects. Thus, the disclosure of the invention is intended to provide a part of the aspects of the present invention, and is not intended to limit the scope of the invention described and claimed herein.

### [Brief Description of Drawings]

[FIG. 1] FIG. 1 is a side view showing a configuration of a vehicle including an openable display apparatus according to an embodiment of the present invention.
[FIG. 2] FIG. 2 is an appearance perspective view of the openable display apparatus in FIG. 1.
[FIG. 3] FIG. 3 is a plan view showing an internal configuration of the openable display apparatus.
[FIG. 4] FIG. 4 is a side view showing a configuration of a display opening/closing portion.
[FIG. 5] FIG. 5 is a side view showing configurations of a holding motor and a drive transmission portion.
[FIG. 6] FIG. 6 is a perspective view showing a positional relationship between a locking lever, a slide lever and a sector gear.
[FIG. 7] FIG. 7(A) is a plan view showing an operation of a display locking portion when the locking lever is in a retraction position. FIG. 7(B) is a plan view showing an operation of the display locking portion when the locking lever is in an insertion position.
[FIG. 8] FIG. 8(A) is a plan view showing an operation of a display braking portion when the slide lever is in a release position. FIG. 8(B) is a plan view showing an operation of the display braking portion when the slide lever is in a braking position.
[FIG. 9] FIG. 9 is a block diagram showing an electrical configuration of the openable display apparatus.
[FIG. 10] FIG. 10 is a flowchart showing a process of pivoting a display to a use position.
[FIG. 11] FIG. 11 is a flowchart showing a process of pivoting the display to a storage position.

### [Description of Embodiment]

Now, the present invention will be described in detail. The detailed description below and accompanying drawings do not limit the invention.

A display holding mechanism according to the present invention includes: a display locking portion that locks a display in a storage position; a display braking portion that brakes the display in a use position; and a switching member that selectively engages the display locking portion and the display braking portion, wherein the switching member engages the display locking portion in a first position to lock the display in the storage position, and engages the display braking portion in a second position to brake the display in the use position.

Specifically, the openable display apparatus does not simultaneously use a drive motor in the use position and the storage position, and thus includes the switching member that causes the display braking portion to engage the drive motor in the use position, and causes the display lock to engage the drive motor in the storage position. This can reduce a size and cost of the apparatus with a simple configuration including a single motor, without damaging a function of reliably holding the display in the use position and the storage position.

In the display holding mechanism of the present invention, the display locking portion includes a locking lever having a pawl to be inserted into an opening formed in the display, and a first engaging portion that is provided on the switching member and engages the locking lever, and when the switching member is in the first position, the first engaging portion engages the locking lever to move the locking lever to a position where the pawl is inserted into the opening. This can reliably lock the display in the storage position while regulating movement of the display in the use position with a simple configuration.

In the display holding mechanism of the present invention, the display braking portion includes a brake portion that holds a pivot shaft of the display to brake the display, a lever member connected to the brake portion, and a second engaging portion that is provided on the switching member and engages the lever member, and when the switching member is in the second position, the second engaging portion engages the lever member to move the lever member and operate the brake portion. This can regulate movement of the display in the use position while reliably locking the display in the storage position with a simple configuration.

In the display holding mechanism of the present invention, when the display is pivoted between the use position and the storage position, the switching member is in an intermediate position where the switching member engages neither the display locking portion nor the display braking portion. This can prevent the display locking portion and the display braking portion from regulating pivoting of the display.

The display apparatus of the present invention includes the above described display holding mechanism, a display that displays an image, and a display opening/closing mechanism that pivots the display between a use position and a storage position. As described above, such a configuration can reliably lock the display, and reduce a size and cost of the apparatus without damaging a function of preventing a rattle of the display in use.

The display apparatus including the display holding mechanism according to the embodiment of the present invention will be described with reference to the drawings.

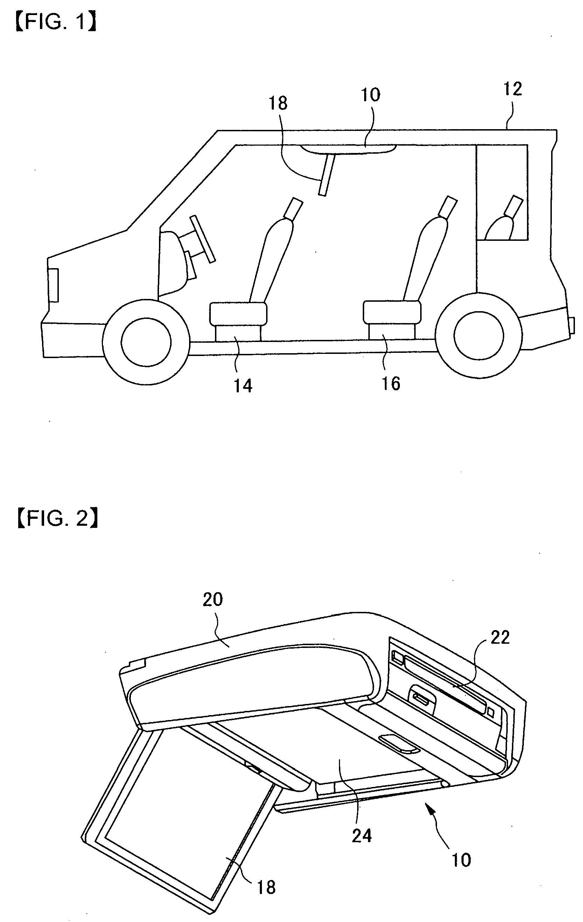

FIG. 1 is a side view of a vehicle including the display apparatus. The display apparatus 10 is secured to an inner surface of a top panel of a vehicle 12 between a front seat 14 and a rear seat 16 of the vehicle 12. The display apparatus 10 includes a display 18 that outputs and displays an image, and the display 18 is configured to protrude downward from an apparatus body. Thus, a fellow passenger in the rear seat can watch an image displayed on the display 18.

FIG. 2 shows an appearance of the display apparatus 10. The display apparatus 10 includes a casing 20, a DVD drive 22, and the display 18. The display 18 is configured to be pivotable between a use position shown in FIG. 2, and a storage position where the display 18 is stored in a storage portion 24 formed in the casing 20.

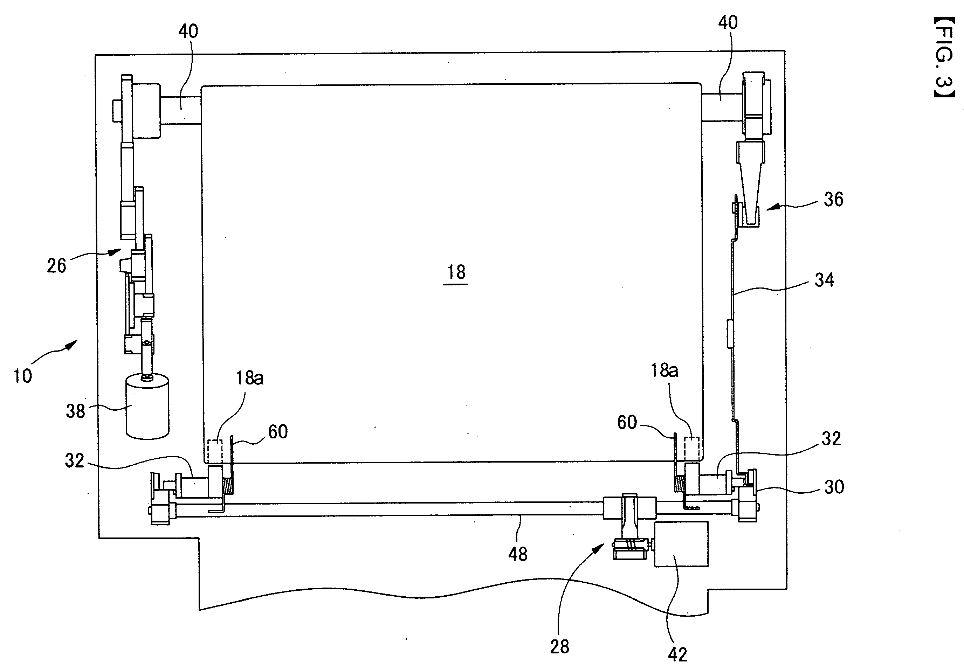

FIG. 3 is a plan view showing a configuration of a driving mechanism of the display apparatus 10. The driving mechanism of the display apparatus 10 includes a display opening/closing portion 26, a drive transmission portion 28, a sector gear 30, a locking lever 32, a slide lever 34, and a brake portion 36. The display opening/closing portion 26 includes an opening/closing motor 38, and the opening/closing motor 38 is driven to rotate a rotating shaft 40 of the display 18, and the display 18 is pivoted between the storage position and the use position. The drive transmission portion 28 includes a holding motor 42, and the holding motor 42 is driven to secure the display 18 in the storage position, and brake the display 18 in the use position.

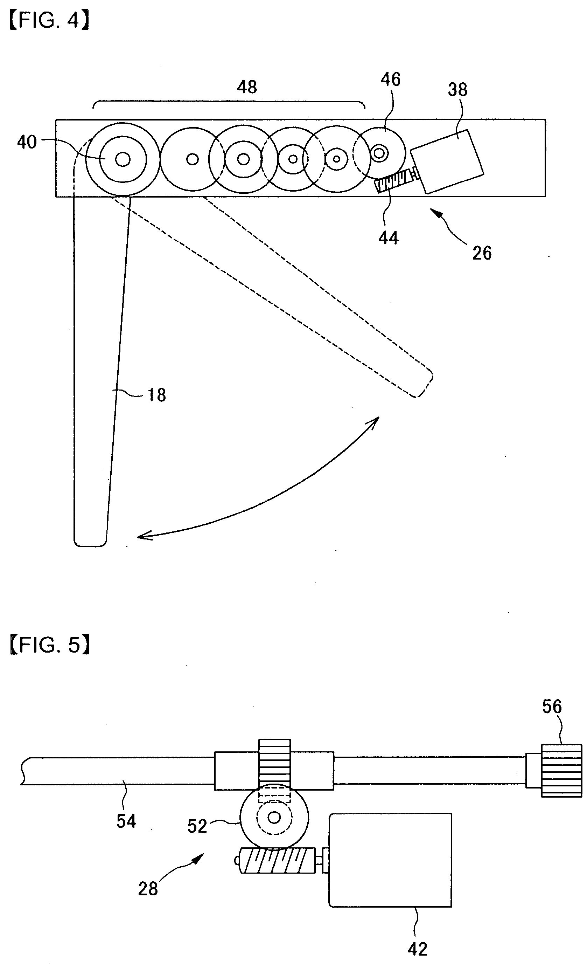

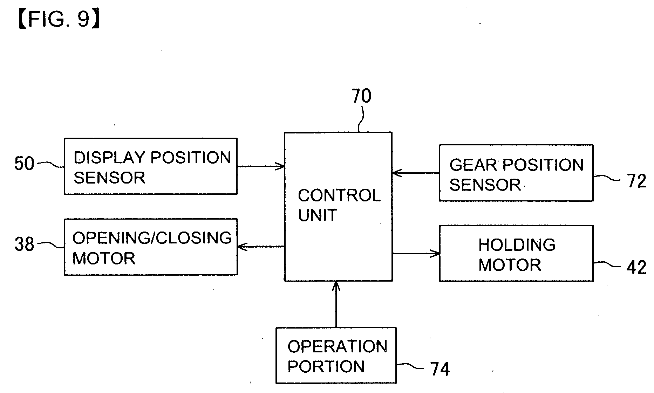

FIG. 4 shows a configuration of the display opening/closing portion 26. The display opening/closing portion 26 includes the opening/closing motor 38, a worm gear 44, a worm wheel 46, and a transmission gear train 48, and the rotating shaft 40 of the display 18 is mounted to the gear at the end of the transmission gear train 48. When the opening/closing motor 38 is driven, a drive force of the opening/closing motor 38 is transmitted to the rotating shaft 40 of the display 18 via the worm gear 44, the worm wheel 46 and the transmission gear train 48, so the display 18 is pivoted between the storage position and the use position. The display 18 includes a display position sensor 50 (see FIG. 9) that detects a pivot position of the display.

FIG. 5 shows a configuration of the drive transmission portion 28. The drive transmission portion 28 includes a reduction gear train 52, a transmission shaft 54 and a pinion gear 56, and is connected to the holding motor 42. The pinion gear 56 is mounted to each end of the transmission shaft 54, and when the holding motor 42 is driven, the drive force is transmitted via the reduction gear train 52 to the transmission shaft 54, and the pinion gear 56 is rotated together with the transmission shaft 54.

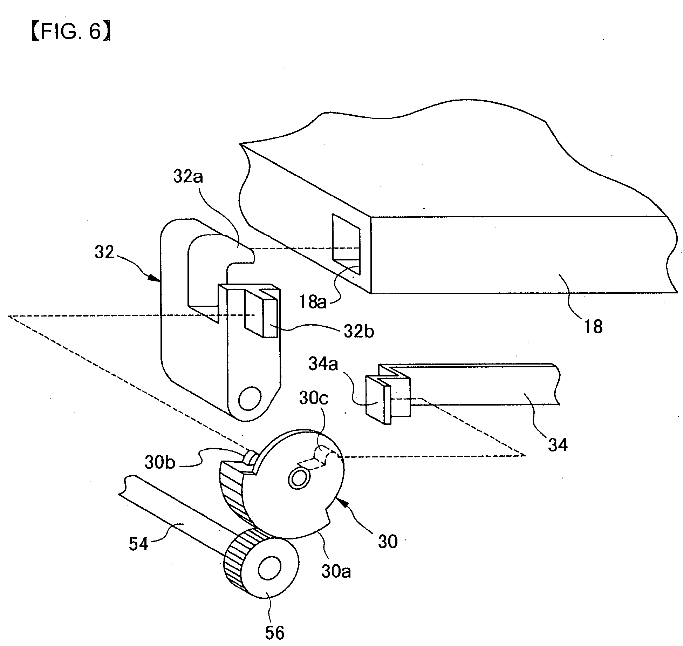

FIG. 6 is a perspective view showing a positional relationship between the sector gear 30, the locking lever 32, and the slide lever 34. The sector gear 30 includes a gear portion 30a that meshes with the pinion gear 56, a first rib 30b for pivoting the locking lever 32, and a second rib 30c for sliding the slide lever 34. In FIG. 6, the second rib 30c is provided on a back surface of the sector gear 30. The sector gear 30 includes a gear position sensor 72 (see FIG. 9) that detects a rotational position of the sector gear 30.

The locking lever 32 is provided to lock the display 18 in the storage position, and includes a pawl 32a and an engagement protrusion 32b. The pawl 32a is formed in an upper part on one side of the locking lever 32, and is inserted into an opening 18a formed in a side surface of the display 18 to lock the display 18 in the storage position. The engagement protrusion 32b is provided on a side surface opposite to the pawl 32a, and has a substantially rectangular parallelepiped shape protruding toward the sector gear 30. The engagement protrusion 32b is placed in a position to engage the first rib 30b of the sector gear 30, and when the sector gear 30 is rotated, the first rib 30b engages the engagement protrusion 32b of the locking lever 32. Thus, the locking lever 32 is pivoted between an insertion position where the pawl 32a is inserted into the opening 18a, and a retraction position where the pawl 32a is retracted from the opening 18a.

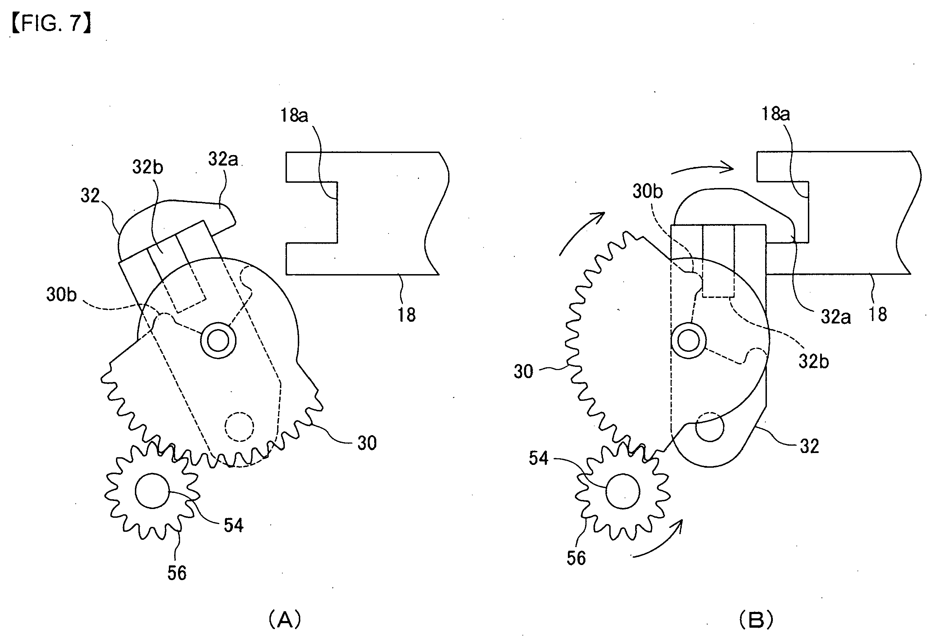

FIG. 7 illustrates an operation of the sector gear 30 and the locking lever 32 locking the display 18, FIG. 7(A) shows a case where the locking lever 32 is in the retraction position, and FIG. 7(B) shows a case where the locking lever 32 is in the insertion position. The locking lever 32 is biased by a torsion spring 60 (see FIG. 3) provided coaxially with the locking lever 32 and held in the retraction position shown in FIG. 7(A).

In this state, when the holding motor 42 is driven to rotate the pinion gear 56 counterclockwise in the drawing, the sector gear 30 is pivoted clockwise, the first rib 30b abuts against and presses the engagement protrusion 32b of the locking lever 32 to pivot the locking lever 32 clockwise in the drawing. When the sector gear 30 reaches a lock position shown in FIG. 7(B), the pawl 32a of the locking lever 32 is inserted into the opening 18a formed in the display 18 in the storage position to press the display 18 in the opening 18a. Thus, the display 18 is secured in the storage position.

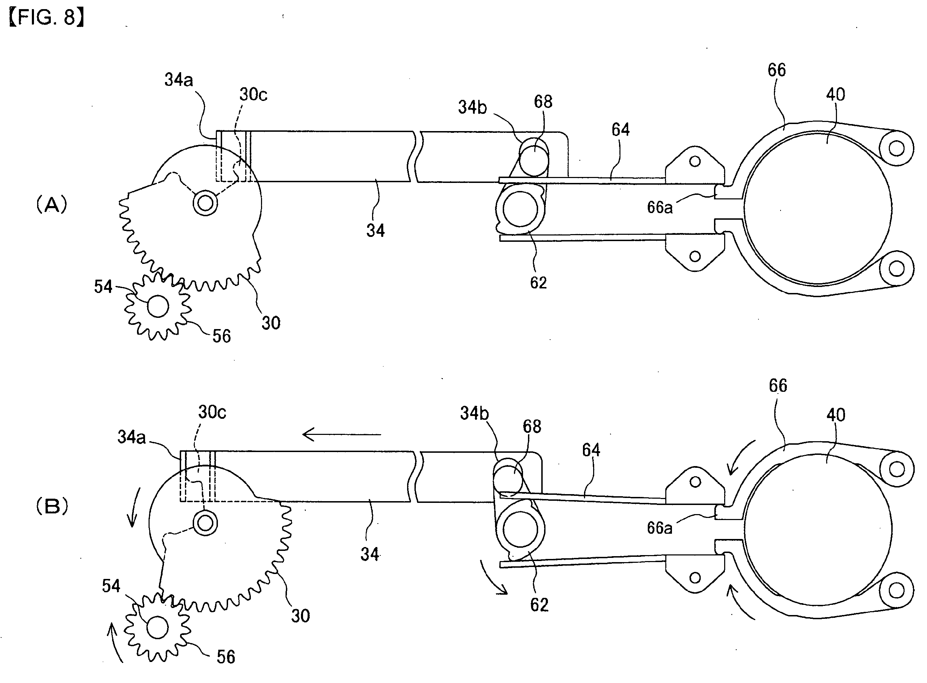

In FIG. 6, the slide lever 34 is connected to a brake portion 36 (FIG. 8) described later, and provided to regulate pivoting of the display 18 in the use position. As shown in FIG. 6, a step-like engaged portion 34a is provided at one end of the slide lever 34, and is placed in a position to engage the second rib 30c provided on the sector gear 30. The slide lever 34 is normally held in a release position where the display 18 is not braked, and when the sector gear 30 is pivoted, the second rib 30c presses the engaged portion 34a of the slide lever 34 to slide the slide lever 34 to the braking position, and the brake portion 36 described later is operated to brake the display 18.

FIG. 8 illustrates a configuration and an operation of the brake portion 36, FIG. 8(A) shows a case where the slide lever 34 is in a release position, and FIG. 8(B) shows a case where the slide lever 34 is in a regulation position. The brake portion 36 includes a cam 62, a brake lever 64, a brake shoe 66, and a link member 68, and a rotating shaft 40 of the display 18 is inserted into a substantially annular brake shoe 66.

An opening 34b is formed on a side opposite to the engaged portion 34a of the slide lever 34, and a pin provided at one end of the link member 68 is inserted into the opening 34b. The cam 62 is provided at the other end of the link member 68, and one end of the brake lever 64 abuts against an outer periphery of the cam 62. The other end of the brake lever 64 abuts against the protrusion 66a formed on the brake shoe 66.

As shown in FIG. 8(A), when the engaged portion 34a of the slide lever 34 does not abut against the second rib 30c of the sector gear 30, the cam 62 is biased by the brake lever 64 and held in a position where the cam 62 is pivoted clockwise in the drawing. Thus, the slide lever 34 is held, via the link member 68 mounted to the cam 62, in the release position where the slide lever 34 is slid to right in the drawing. In this state, the brake lever 64 does not press down the protrusion 66a of the brake shoe 66, and the substantially annular brake shoe 66 is away from the rotating shaft 40 of the display 18. Thus, the display 18 can be pivoted without being braked by the brake shoe 66.

In this state, when the holding motor 42 is driven to rotate the pinion gear 56 clockwise in the drawing, the sector gear 30 is pivoted counterclockwise. Then, the engaged portion 34a of the slide lever 34 abuts against the second rib 30c of the sector gear 30, and presses the second rib 30c to left in the drawing toward the braking position. As shown in FIG. 8(B), when the slide lever 34 is slid, the cam 62 is rotated clockwise in the drawing via the link member 68 engaging the slide lever 34.

When the sector gear 30 reaches the braking position shown in FIG. 8(B), the protrusion of the cam 62 presses up one end of the brake lever 64, and thus a reaction thereof causes the brake lever 64 to fasten the protrusion 66a of the brake shoe 66. Thus, the brake shoe 66 abuts against the rotating shaft 40 of the display 18, and the rotating shaft 40 is fastened by the brake shoe 66 to brake the display 18.

FIG. 9 shows an example of an electrical configuration of the openable display apparatus. The control unit 70 receives positional information from a display position sensor 50 that detects a pivot position of the display 18, and a gear position sensor 72 that detects a pivot position of the sector gear 30 to control outputs to the opening/closing motor 38 and the holding motor 42. An operation portion 74 is operated by a user to pivot the display 18 between the use position and the storage position.

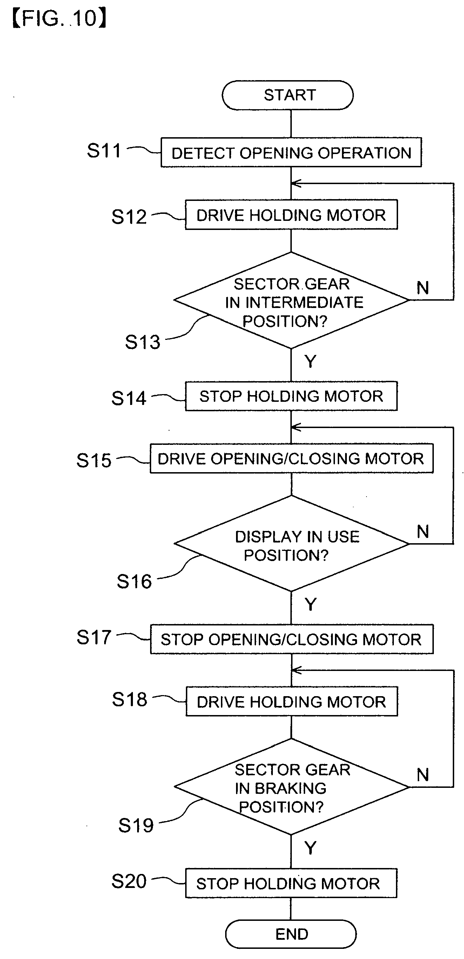

A flowchart in FIG. 10 shows a procedure of pivoting the display to the use position. When the display 18 is in the storage position, the sector gear 30 is in a lock position shown in FIG. 7(B), and the display 18 is locked by the pawl 32a of the locking lever 32. In this state, if it is detected that the user operates the operation portion 74 (S11), the control unit 70 drives the holding motor 42 to pivot the sector gear 30 (S12). Thereby, the locking lever 32 is pivoted, and the pawl 32a is retracted from the opening 18a in the display 18.

If the sector gear is moved to the braking position (see FIG. 8(B)), rotation of the rotating shaft 40 of the display 18 is regulated as described later. Thus, the control unit 70 detects whether the second rib 30c of the sector gear 30 reaches an intermediate position (for example, the position shown in FIG. 7(A)) where the second rib 30c does not abut against the engaged portion 34a of the slide lever 34, based on a position signal from the gear position sensor 72 (S13). When the second rib 30c reaches the intermediate position, the control unit 70 stops the holding motor 42 to stop rotation of the sector gear 30 (S14). Thereby, the display 18 can be pivoted without being braked by the brake shoe 66.

Then, the control unit 70 drives the opening/closing motor 38 to pivot the display 18 from the storage position toward the use position (S15). Then, by a position signal from the display position sensor 50, it is detected whether the display 18 reaches the use position (S16). When it is detected that the display 18 reaches the use position, the control unit 70 stops the opening/closing motor 38 (S17), and drives the holding motor 42 to pivot the sector gear 30 to the regulation position shown in FIG. 8(B) (S18). When it is detected that the sector gear 30 reaches the braking position (S19), the control unit 70 stops the holding motor 42 (S20).

Thereby, the slide lever 34 is pressed by the sector gear 30 and slid, and the cam 62 presses up the brake lever 64. Thus the rotating shaft 40 of the display 18 is fastened by the brake shoe 66. This regulates the movement of the display 18 in the use position, and prevents the risk of a rattle of the display 18 due to vibration of the driving vehicle.

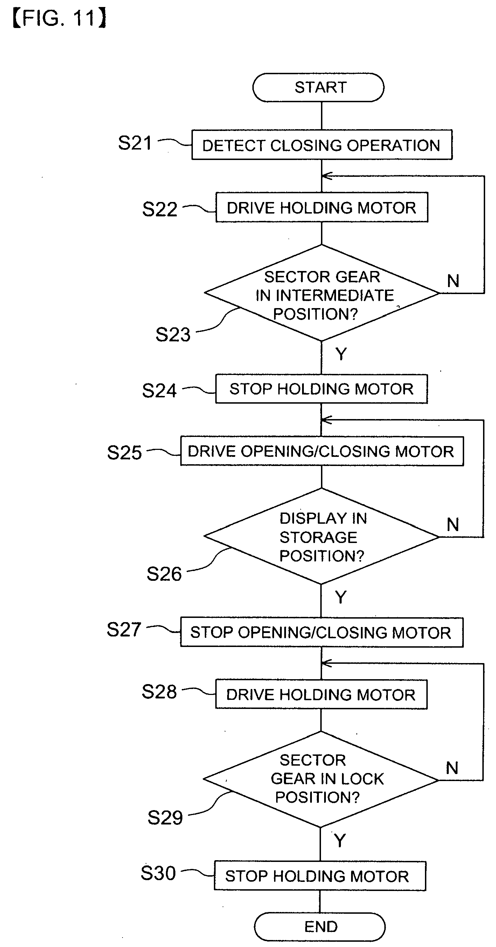

A flowchart in FIG. 11 shows a procedure of pivoting the display to the storage position. When it is detected that the user operates the operation portion 74 (S21), the control unit 70 drives the holding motor 42 to pivot the sector gear 30 in the regulation position toward the lock position (S22). Then, when it is detected, based on a position signal from the gear position sensor 72, that the sector gear 30 is moved to the intermediate position (the position shown in FIG. 8(A)) where the slide lever 34 is disengaged from the sector gear 30 (S23), the control unit 70 stops driving of the holding motor 42 (S24).

This releases regulation of the rotating shaft 40 by the brake shoe 66. Pivoting of the sector gear 30 can be stopped in midstream to prevent the pawl 32a of the locking lever 32 from entering a pivoting area of the display 18 before the display 18 is pivoted to the storage position. The intermediate position of the sector gear in an opening operation (see FIG. 10) may be different from an intermediate position of the sector gear in a closing operation (FIG. 11).

Then, the control unit 70 drives the opening/closing motor 38 (S25) to pivot the display 18 from the use position to the storage position. When it is detected that the display 18 reaches the storage position based on a position signal from the display position sensor 50 (S26), the control unit 70 stops the opening/closing motor 38 (S27). Then, the control unit 70 again drives the holding motor 42 to rotate the sector gear 30 (S28). The sector gear 30 is pivoted to engage the locking lever 32, and the pawl 32a of the locking lever 32 is inserted into the opening 18a in the display 18. Thus, the display 18 can be secured to the storage position.

Then, when it is detected that the sector gear 30 reaches the braking position (S29), the control unit 70 stops the holding motor 42 (S30).

As such, the single motor is used to lock the display in the storage position, and regulate the movement of the display in the use position. This can reliably lock the display, and reduce a size and cost of the apparatus without damaging a function of preventing a rattle of the display in use.

The embodiment of the present invention has been described above by way of example, but the scope of the present invention is not limited to this, and may be changed or varied for any purpose within the scope of claims. For example, the sector gear, the locking lever, and the slide lever are not limited to the shown shapes, but may have various shapes as long as they provide the same operation and effect as the present invention.

In the above described embodiment, the holding motor is placed on the locking lever 32, but may be placed on the brake portion 36. In the above described embodiment, the display opening/closing portion 26 is placed only on one side of the display 18, but may be placed on both sides of the display 18.

In the above described embodiment, the openable display apparatus for a vehicle is taken as an example for description, but the present invention is not limited to this, and may be similarly applied to, for example, an openable display apparatus provided in a cabin area of aircraft.

### [Industrial Applicability]

The openable display apparatus of the present invention can reliably lock the display, and reduce a size and cost of the driving mechanism without damaging a function of preventing a rattle of the display in use, and is useful as a display apparatus for a vehicle.

### [Reference Signs List]

- 10: openable display apparatus
- 18: display
- 18a: opening
- 26: display opening/closing portion
- 28: drive transmission portion
- 30: sector gear
- 30b: first rib
- 30c: second rib
- 32: locking lever
- 32a: pawl
- 32b: engagement protrusion
- 34: slide lever
- 34a: engaged portion
- 36: brake portion
- 38: opening/closing motor
- 40: rotating shaft
- 42: holding motor
- 50: display position sensor
- 70: control unit
- 72: gear position sensor

## Claims

1. A display holding mechanism that holds a display (18) pivotable between a use position and a storage position, comprising:
a display locking portion that locks the display (18) in the storage position;
a display braking portion that brakes the display (18) in the use position; **characterized by** further comprising
a switching member (30) that selectively engages the display locking portion and the display braking portion,
wherein the switching member (30) engages the display locking portion in a first position to lock the display (18) in the storage position, and engages the display braking portion in a second position to brake the display (18) in the use position.

2. The display holding mechanism according to claim 1, wherein the display locking portion includes a locking lever (32) having a pawl (32a) to be inserted into an opening (18a) formed in the display (18), and a first engaging portion (30b) that is provided on the switching member (30) and engages the locking lever (32), and
wherein when the switching member (30) is in the first position, the first engaging portion (30b) engages the locking lever (32) to move the locking lever (32) to a position where the pawl (32a) is inserted into the opening (18a).

3. The display holding mechanism according to claim 1, wherein the display braking portion includes a brake portion (36) that holds a pivot shaft of the display (18) to brake the display (18) a lever member (34) connected to the brake portion (36), and a second engaging portion (30c) that is provided on the switching member (30) and engages the lever member (34), and
wherein when the switching member (30) is in the second position, the second engaging portion (30c) engages the lever member (34) to move the lever member (34) and operate the brake portion (36).

4. The display holding mechanism according to claim 1, wherein when the display (18) is pivoted between the use position and the storage position, the switching member (30) is in an intermediate position where the switching member (30) engages neither the display locking portion nor the display braking portion.

5. An openable display apparatus comprising:
a display holding mechanism according to claim 1;
a display (18) that displays an image; and
a display opening/closing mechanism that pivots the display (18) between the use position and the storage position.

## Patentansprüche

1. Display-Haltemechanismus, der ein Display (18) hält, das zwischen einer Einsatz-Position und einer Verstau-Position geschwenkt werden kann, wobei er umfasst:
einen Display-Arretierabschnitt, der das Display (18) in der Verstau-Position arretiert;
einen Display-Bremsabschnitt, der das Display (18) in der Einsatz-Position bremst;
**dadurch gekennzeichnet,** das er des Weiteren umfasst:
ein Umstell-Element (30), das selektiv mit dem Display-Arretierabschnitt und dem Display-Bremsabschnitt in Eingriff kommt,
wobei das Umstell-Element (30) in einer ersten Position mit dem Display-Arretierabschnitt in Eingriff kommt, um das Display (18) in der Verstau-Position zu arretieren, und in einer zweiten Position mit dem Display-Bremsabschnitt in Eingriff kommt, um das Display (18) in der Einsatz-Position zu bremsen.

2. Display-Haltemechanismus nach Anspruch 1, wobei der Display-Arretierabschnitt einen Arretierhebel (32), der eine Klinke (32a) aufweist, die in eine Öffnung (18a) eingeführt wird, die in dem Display (18) ausgebildet ist, sowie einen ersten Eingriffsabschnitt (30b) enthält, der sich an dem Umstell-Element (30) befindet und mit dem Arretierhebel (32) in Eingriff kommt; und
wobei, wenn sich das Umstell-Element (30) in der ersten Position befindet, der erste Eingriffsabschnitt (30b) mit dem Arretierhebel (32) in Eingriff kommt, um den Arretierhebel (32) an eine Position zu bewegen, an der die Klinke (32a) in die Öffnung (18a) eingeführt ist.

3. Display-Haltemechanismus nach Anspruch 1, wobei der Display-Bremsabschnitt einen Bremsabschnitt (36), der eine Schwenkwelle des Displays (18) hält, um das Display (18) zu bremsen, ein Hebel-Element (34), das mit dem Bremsabschnitt (36) verbunden ist, sowie einen zweiten Eingriffsabschnitt (30c) enthält, der sich an dem Umstell-Element (30) befindet und mit dem Hebel-Element (34) in Eingriff ist, und
wobei, wenn sich das Umstell-Element (30) in der zweiten Position befindet, der zweite Eingriffsabschnitt (30c) mit dem Hebel-Element (34) in Eingriff kommt, um das Hebel-Element (34) zu bewegen und den Bremsabschnitt (36) zu betätigen.

4. Display-Haltemechanismus nach Anspruch 1, wobei, wenn das Display (18) zwischen der Einsatz-Position und der Verstau-Position geschwenkt wird, sich das Umstell-Element (30) in einer Zwischenposition befindet, in der das Umstell-Element (30) weder mit dem Display-Arretierabschnitt noch mit dem Display-Bremsabschnitt in Eingriff ist.

5. Zu öffnende Anzeigevorrichtung, die umfasst:
einen Display-Haltemechanismus nach Anspruch 1;
ein Display (18), das ein Bild anzeigt; sowie
einen Mechanismus zum Öffnen/Schließen des Displays, der das Display (18) zwischen der Einsatz-Position und der Verstau-Position schwenkt.

## Revendications

1. Mécanisme de maintien d'affichage qui maintient un affichage (18) pivotable entre une position d'utilisation et une position de stockage, comprenant :
une portion de verrouillage d'affichage qui verrouille l'affichage (18) dans la position de stockage ;
une portion de freinage d'affichage qui freine l'affichage (18) dans la position d'utilisation ;
**caractérisé en ce qu'**il comprend en outre :
un élément de commutation (30) qui s'engage sélectivement avec la portion de verrouillage d'affichage et la portion de freinage d'affichage,
dans lequel l'élément de commutation (30) s'engage avec la portion de verrouillage d'affichage dans une première position pour verrouiller l'affichage (18) dans la position de stockage, et s'engage avec la portion de freinage d'affichage dans une deuxième position pour freiner l'affichage (18) dans la position d'utilisation.

2. Mécanisme de maintien d'affichage selon la revendication 1,
dans lequel la portion de verrouillage d'affichage comprend un levier de verrouillage (32) qui comporte un cliquet (32a) à insérer dans une ouverture (18a) formée dans l'affichage (18), et une première portion d'engagement (30b) qui est pourvue sur l'élément de commutation (30) et qui s'engage avec le levier de verrouillage (32), et
dans lequel, quand l'élément de commutation (30) se trouve dans la première position, la première portion d'engagement (30b) s'engage avec le levier de verrouillage (32) pour déplacer le levier de verrouillage (32) dans une position où le cliquet (32a) est inséré dans l'ouverture (18a).

3. Mécanisme de maintien d'affichage selon la revendication 1,
dans lequel la portion de freinage d'affichage comprend une portion de freinage (36) qui maintient un axe de pivotement de l'affichage (18) pour freiner l'affichage (18), un élément de levier (34) connecté à la portion de freinage (36), et une deuxième portion d'engagement (30b) qui est pourvue sur l'élément de commutation (30) et qui s'engage avec l'élément de levier (34), et
dans lequel, quand l'élément de commutation (30) se trouve dans la deuxième position, la deuxième portion d'engagement (30c) s'engage avec l'élément de levier (34) pour déplacer l'élément de levier (34) et actionner la portion de freinage (36).

4. Mécanisme de maintien d'affichage selon la revendication 1, dans lequel, quand l'affichage (18) est pivoté entre la position d'utilisation et la position de stockage, l'élément de commutation (30) se trouve dans une position intermédiaire où l'élément de commutation (30) ne s'engage ni avec la portion de verrouillage d'affichage, ni avec la portion de freinage d'affichage.

5. Appareil d'affichage ouvrable comprenant :
un mécanisme de maintien d'affichage selon la revendication 1 ;
un affichage (18) qui affiche une image ; et
un mécanisme d'ouverture/fermeture d'affichage qui fait pivoter l'affichage (18) entre la position d'utilisation et la position de stockage.
